(19) Europäisches Patentamt
European Patent Office
Office européen des brevets

(11) **EP 2 141 266 B1**

(12) **EUROPEAN PATENT SPECIFICATION**

(45) Date of publication and mention
of the grant of the patent:
**04.04.2012 Bulletin 2012/14**

(51) Int Cl.:
***C30B 11/00*** *(2006.01)*          ***C30B 13/14*** *(2006.01)*
***C30B 15/10*** *(2006.01)*          ***C30B 35/00*** *(2006.01)*

(21) Application number: **09164154.8**

(22) Date of filing: **30.06.2009**

(54) **Silica glass crucible and method of pulling silicon single crystal with silica glass crucible**

Quarzglastiegel und Verfahren zum Ziehen von Siliciumeinkristall mit dem Quarzglastiegel

Creuset en verre de silice et procédé de tirage de silicium monocristallin avec le creuset en verre de silice

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **30.06.2008 JP 2008170278
25.06.2009 JP 2009150729**

(43) Date of publication of application:
**06.01.2010 Bulletin 2010/01**

(73) Proprietor: **Japan Super Quartz Corporation
Akita City
Akita 010-0065 (JP)**

(72) Inventor: **Kishi, Hiroshi
c/o Japan Super Quartz Corporation
Akita 010-0065 (JP)**

(74) Representative: **Gulde Hengelhaupt Ziebig &
Schneider
Patentanwälte - Rechtsanwälte
Wallstraße 58/59
10179 Berlin (DE)**

(56) References cited:
**EP-A1- 0 530 825          JP-A- 2005 320 241
JP-A- 2008 094 639          US-A- 5 306 388**

**Description**

BACKGROUND OF THE INVENTION

1. Field of the Invention

The present invention relates to a silica glass crucible used for pulling a silicon single crystal as a semiconductor material, a silicon crystal as a solar battery material or the like, and more particularly to a silica glass crucible allowing the pulling of a silicon single crystal with a high crystallization rate and a method of pulling a silicon single crystal with the silica glass crucible.

2. Description of the Related Art

A silica glass crucible is used for pulling a silicon single crystal as a semiconductor material, a silicon crystal as a solar battery material or the like. For example, the silicon single crystal is mainly produced by a method in which a polycrystalline silicon lump charged in a silica glass crucible is melted by heating to form a silicon melt and a seed crystal is immersed in the silicon melt and pulled therefrom. The silicon crystal as a solar battery material is low in the single-crystallinity as compared with the silicon single crystal, but is produced by the same pulling method.

The pulling of the silicon crystal is carried out by uniformly heating the silicon melt while rotating the silica glass crucible. In this case, if the bubble content and transmission in the circumferential direction of the crucible are non-uniform, brown rings produced in the inner surface of the crucible become unevenly distributed. Also, when the thickness of the crucible is non-uniform, the crucible form becomes faulty.

In the pulling of the silicon crystal, when the inner surface of the crucible is brought in contact with the silicon melt at a higher temperature for an expended period of time, a shallow surface layer inside the crucible is partially crystallized to generate a brown cristobalite in a ring shape (brown ring). As the uneven distribution of the brown rings or the faulty crucible form becomes significant, flaking portions in the inner surface of the crucible increase and the flaked fragments are incorporated into the silicon melt to reduce the crystallinity of the silicon crystal.

When the inner surface of the crucible is in contact with the silicon melt at a higher temperature for an extended period of time, SiO gas is generated by a reaction between the crucible inner surface and the silicon melt, whereby the silicon melt is oscillated to reduce the crystallinity of the silicon crystal.

In JP-A-2005-320241 is proposed a method of stably pulling a silicon crystal by restricting the number of brown rings within a certain range. In JP-A-2002-154894 is proposed that liquid-level oscillation of the silicon melt is prevented by using a silica glass crucible controlling an amount of SiO gas generated to not more than a certain level.

EP 0530825 A1 describes a single crystal growing apparatus for growing a single crystal ingot from a molten semiconductor material comprising a crucible assembly consisting of at least two crucibles in the form of an outer crucible and an inner crucible. The inner crucible contains air bubbles of not more than 0,05 % of the total volume of the inner crucible and a light transmissivity which is not less than 70 % of the total under a light of 240 nm wave length or more.

A silica glass crucible for pulling up a semiconductor single crystal in good yield and preventing an impurity contamination is disclosed in JP-A-2008-094639. In a silica glass crucible comprising a transparent silica glass layer at the inside surface side and an opaque silica glass layer containing closed bubbles at the outer periphery, the part at 500 $\mu$m from the inside surface of the crucible in the thickness direction is composed of having fluorescence intensity at the peak wavelength of 390 nm of 0.15 or lower of the base fluorescence intensity at the wavelength of 560 nm of the 10 ppb ethanol solution of rhodamine B when irradiating an excitation light having the wavelength of 242 nm.

SUMMARY OF THE INVENTION

It is, therefore, an object of the invention to solve the aforementioned problems on the reduction of the crystallinity due to brown rings or SiO gas generated in the pulling of the silicon crystal. According to the invention, there are provided standards of bubble content, thickness and transmission as measured over a circumference of a silica glass crucible at a given height position thereof for achieving a crystallinity of a silicon crystal above a given value, specifically acceptable ranges thereof in the silica glass crucible for obtaining a silicon crystal with a crystallinity of, for example, not less than 80%.

The invention is concerned with a silica glass crucible having the following construction:

(1) A silica glass crucible used for pulling a silicon crystal, characterized in that a circumferential maximum tolerance of each of bubble content, wall thickness and transmission as measured over a full circumference of the crucible at a same height position is not more than 6%.

(2) A silica glass crucible according to the item (1), wherein the circumferential maximum tolerance of each of the bubble content, wall thickness and transmission is not more than 3%.

(3) A silica glass crucible according to the item (1), wherein the circumferential maximum tolerance of each of the bubble content, wall thickness and transmission is not more than 1.5%.

(4) A method of pulling a silicon single crystal, comprising using a silica glass crucible as described in any one of the items (1) to (3).

The silica glass crucible according to the invention is a silica glass crucible used for pulling a silicon crystal in which a circumferential maximum tolerance of each of bubble content, wall thickness and transmission as measured over a full circumference of the crucible at a same height position is not more than 6%, so that a higher crystallinity can be attained without substantially causing the liquid-level oscillation of the silicon melt and the flaking of the crucible inner surface during the pulling of the silicon crystal.

BRIEF DESCRIPTION OF THE DRAWING

The invention will be described with reference to the accompanying drawing, wherein

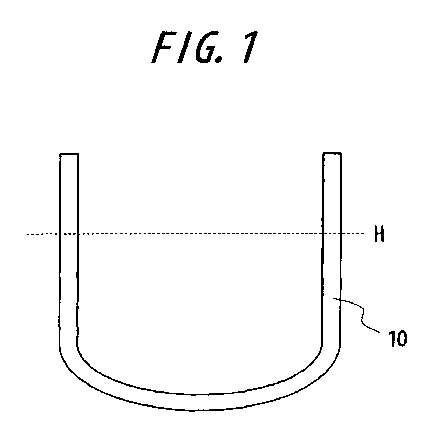

FIG. 1 is a longitudinal sectional view of a silica glass crucible.

DESCRIPTION OF THE PREFERRED EMBODIMENTS

The silica glass crucible according to the invention is a silica glass crucible used for pulling a silicon crystal. In FIG. 1 is shown a schematically longitudinal sectional view of the silica glass crucible according to the invention. In the silica glass crucible 10 according to the invention, the circumferential maximum tolerance of each of bubble content, wall thickness and transmission at the same crucible height position H is not more than 6%, preferably not more than 3%, more preferably not more than 1.5%.
The term "circumferential maximum tolerance" used herein is a percentage of a value obtained by subtracting an average value of each of the bubble content, wall thickness and transmission as measured over the full circumference of the crucible at the same height position from a value most deviated therefrom. For example, when the average value is A and the value most deviated from the average value is B, the circumferential maximum tolerance X (%) is given by the following equation [1]:

$$\text{Circumferential maximum tolerance } X\ (\%) = \text{Absolute value of } (B-A) \ / \ A \times 100 \cdots [1]$$

When the crucible is constituted with a two-layer structure of an outer layer made of natural quartz glass and an inner layer made of synthetic silica glass, the bubble content means a bubble content of the inner layer, concretely a bubble content of a transparent glass layer forming the inner layer of the crucible. Generally, in case of the silica glass crucible having a diameter of 81.28 cm (32 inches), the transparent glass layer as an inner layer of the crucible corresponds to a layer portion having a thickness of about 0.5 to 10 mm from the inner surface of the crucible.
The wall thickness is a shortest distance of a section portion ranging from the inner surface to the outer surface of the crucible.
The transmission is a transmission of a section portion ranging from the outer surface to the inner surface of the crucible.
Moreover, the same height position H of the crucible may have a certain width required for measuring the bubble content, wall thickness and transmission.
The crystallinity of not less than 80% can be obtained in the pulling of a silicon crystal by controlling the circumferential uniformity of the silica glass crucible so that the circumferential maximum tolerance of each of the bubble content, wall thickness and transmission at the same height position of the crucible is not more than 6%.
On the other hand, if the circumferential maximum tolerance of either of the bubble content, wall thickness and transmission of the silica glass crucible exceeds 6%, the crystallinity significantly lowers. Incidentally, the flaking tends to be caused on the inner surface of the crucible when the circumferential maximum tolerances of the bubble content and wall thickness exceed 6%, while the liquid-level oscillation of the silicon melt tends to be caused when the circumferential maximum tolerance of the transmission exceeds 6%. In any cases, the crystallinity significantly lowers.

The silica glass crucible of the invention can be produced by a method of producing a crucible by depositing silica or quartz powder on an inner surface of a rotating crucible-like mold and heating the silica or quartz powder layer at a higher temperature to be vitrified under the rotation of the mold, wherein a dial gauge is put on the inner surface of the mold and a lateral oscillating level of the inner surface is controlled to not more than 0.1% of an inner diameter of the mold.

The invention will be described concretely with reference to examples and comparative examples. Moreover, the bubble content, wall thickness and transmission are measured by the following methods. Also, the crystallinity is determined by a ratio of weight of a straight base portion of a pulled crystal ingot to weight of a starting material charged.

The height position H of the crucible to be measured is set to a height at a middle position between a bottom position of the crucible and an upper end position of a sidewall portion of the crucible when an opening of the crucible is in an upward direction (in case of a 71.12 cm (28 inch) crucible as an example, the height position H is 250 mm from the bottom position of the crucible).

The bubble content is determined by an area of bubbles occupied per unit area in a transparent layer as an inner layer of the crucible (a portion having a thickness of 1 mm from the inner surface of the crucible).

The wall thickness is determined by measuring wall thickness ranging from the outer surface to the inner surface of the crucible at the measuring height position and calculating an average value thereof.

The transmission is calculated by the following equation:

$$\text{Transmission (\%)} = W1/W0 \times 100$$

when an infrared ray quantity at a state of disposing the crucible between an infrared ray irradiation apparatus and an infrared ray measuring instrument is W1 and an infrared ray quantity at a state of disposing no crucible between an infrared ray irradiation apparatus and an infrared ray measuring instrument is W0.

Examples 1 to 3

A silica glass crucible according to the invention (inner diameter: 81.28 cm (32 inches)) is produced according to conditions shown in Table 1, and then a silicon crystal is pulled. The results are shown in Table 1.

Comparative Examples 1 to 4

A silica glass crucible (inner diameter: 81.28 cm (32 inches)) is produced conditions shown in Table 1, and then a silicon crystal is pulled. The results are shown in Table 1.

Table 1

| | | Circumferential maximum tolerance (%) | | | Liquid-level oscillation | Flaking of inner surface | Crystallinity (%) |
|---|---|---|---|---|---|---|---|
| | | Bubble content | Wall thicknes | Transmission | | | |
| | Example 1 | 1.3 | 1.1 | 1.2 | None | None | 84 |
| | Example 2 | 2.5 | 2.7 | 2.9 | None | None | 82 |
| | Example 3 | 5.8 | 5.6 | 5.4 | None | None | 80 |
| | Comparative Example 1 | 6.9 | 1.8 | 1.5 | None | Existent | 39 |
| | Comparative Example 2 | 2.2 | 7.2 | 2.8 | None | Existent | 36 |
| | Comparative Example 3 | 1.8 | 2.7 | 7.7 | Existent | None | 41 |
| | Comparative Example 4 | 7.2 | 8.2 | 7.6 | Existent | Existent | 30 |

As seen from Table 1, the crystallinity of not less than 80% is obtained without causing liquid-level oscillation of silicon melt and flaking the inner surface of the crucible in all of Examples 1 to 3. Moreover, the crystallinity is 80% in Example 3 wherein the circumferential maximum tolerance of each of the bubble content, wall thickness and transmission is more than 3% but not more than 6%, while the crystallinity is as high as 82% in Example 2 wherein the circumferential maximum tolerance is more than 1.5% but not more than 3%, and also the crystallinity is the highest of 84% in Example 1 wherein the circumferential maximum tolerance is not more than 1.5%. On the other hand, the crystallinity is not more than 41% in any of Comparative Examples 1 to 3, which is considerably lower than those of Examples 1 to 3. Particularly in Comparative Example 4 wherein the circumferential maximum tolerance of each of the bubble content, wall thickness and transmission exceeds 6%, the liquid-level oscillation of silicon melt and the flaking of the inner surface of the crucible are caused and the crystallinity is the lowest of 30%.

## Claims

1. A silica glass crucible used for pulling a silicon crystal, **characterized in that** a circumferential maximum tolerance of each of bubble content, wall thickness and transmission as measured over a full circumference of the crucible at a same height position is not more than 6%, wherein
the circumferential maximum tolerance (%) is defined by an absolute value of $(B-A)/A \times 100$, where A is an average value as measured over the full circumference of the crucible at the same height position and B is a value most deviated from the average value;
the bubble content is defined by an area of bubbles occupied per unit area in a transparent layer as an inner layer of the crucible, the inner layer being a portion having a thickness of 1 mm from the inner surface of the crucible; and
the transmission (%) is defined by $W1/W0 \times 100$, where W1 is an infrared ray quantity at a state of disposing the crucible between an infrared ray irradiation apparatus and an infrared ray measuring instrument and W0 is an infrared ray quantity at a state of disposing no crucible between an infrared ray irradiation apparatus and an infrared ray measuring instrument.

2. A silica glass crucible according to claim 1, wherein the circumferential maximum tolerance of each of the bubble content, wall thickness and transmission is not more than 3%.

3. A silica glass crucible according to claim 1, wherein the circumferential maximum tolerance of each of the bubble content, wall thickness and transmission is not more than 1.5%.

4. A method of pulling a silicon single crystal, comprising using a silica glass crucible as claimed in any one of claims 1 to 3.

## Patentansprüche

1. Quarzglastiegel zum Ziehen von Silicium-Kristallen, **dadurch gekennzeichnet dass** die jeweilige umfangbezogene maximale Toleranz von Blasengehalt, Wandstärke und Durchlässigkeit, gemessen über den vollen Umfang des Tiegels in der gleichen Höhenposition, nicht mehr als 6% beträgt, wobei
die umfangbezogene maximale Toleranz (%) definiert ist durch den Absolutwert von $(B - A)/A - 100$, worin A der über den gesamten Umfang des Tiegels an der gleichen Höhenposition gemessene Mittelwert und B der am meisten vom Mittelwert abweichende Wert ist;
der Blasengehalt definiert ist durch die pro Flächeneinheit eingenommene Blasenfläche in einer transparenten Schicht als innere Schicht des Tiegels, wobei die innere Schicht ein Bereich mit einer Dicke von 1 mm von der Innenfläche des Tiegels ist; und
die Durchlässigkeit (%) definiert ist durch $W1/W0 - 100$, worin W1 die Infrarotstrahlenmenge ist, wenn sich der Tiegel zwischen einem Infrarotbestrahlungsgerät und einem Messinstrument für Infrarotstrahlung befindet und W0 die Infrarotstrahlenmenge ist, wenn sich kein Tiegel zwischen dem Infrarotbestrahlungsgerät und dem Messinstrument für Infrarotstrahlung befindet.

2. Quarzglastiegel nach Anspruch 1, wobei die jeweilige umfangbezogene maximale Toleranz von Blasengehalt, Wandstärke und Durchlässigkeit nicht mehr als 3% beträgt.

3. Quarzglastiegel nach Anspruch 1, wobei die jeweilige umfangbezogene maximale Toleranz von Blasengehalt, Wandstärke und Durchlässigkeit nicht mehr als 1,5% beträgt.

**4.** Verfahren zum Ziehen von Silicium-Einkristallen, umfassend die Verwendung eines Quarzglastiegels nach einem der Ansprüche 1 bis 3.

**Revendications**

**1.** Creuset en verre de silice utilisé pour tirer un cristal de silicium, **caractérisé en ce qu'**une tolérance maximale circonférentielle pour chacune de la teneur en bulles, de l'épaisseur de paroi et de la transmission, telles qu'elles sont mesurées sur une circonférence complète du creuset à une position de même hauteur, n'est pas supérieure à 6 %, dans lequel

la tolérance maximale circonférentielle (en %) est définie par une valeur absolue (B-A) / A x 100, A représentant une valeur moyenne mesurée sur la circonférence entière du creuset à la même position en hauteur et B étant une valeur la plus écartée de la valeur moyenne,

la teneur en bulles est définie par la surface des bulles occupée par unité de surface dans une couche transparente à titre de couche intérieure du creuset, la couche intérieure étant une portion ayant une épaisseur de 1 mm à partir de la surface intérieure du creuset, et

la transmission (%) est définie par W1/W0 x 100, W1 étant une quantité de rayonnement infrarouge dans un état d'agencement du creuset entre un appareil d'irradiation de rayon infrarouge et un instrument de mesure de rayon infrarouge et W0 étant une quantité de rayonnement infrarouge dans un état dans lequel il n'y a pas de creuset disposé entre l'appareil d'irradiation de rayon infrarouge et un instrument de mesure de rayon infrarouge.

**2.** Creuset en verre de silice selon la revendication 1, dans lequel la tolérance maximale circonférentielle de chacune de la teneur en bulles, de l'épaisseur de paroi et de la transmission n'est pas supérieure à 3 %.

**3.** Creuset en verre de silice selon la revendication 1, dans lequel la tolérance maximale circonférentielle de chacune de la teneur en bulles, de l'épaisseur de paroi et de la transmission n'est pas supérieure à 1,5 %.

**4.** Procédé de tirage d'un monocristal de silicium, comprenant l'utilisation d'un creuset en verre de silice selon l'une quelconque des revendications 1 à 3.

FIG. 1

**EP 2 141 266 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005320241 A
- JP 2002154894 A
- EP 0530825 A1
- JP 2008094639 A